# FASCICULE DE BREVET EUROPEEN

(11) **EP 1 573 399 B1**
(45) Date de publication et mention de la délivrance du brevet: **05.07.2006**
(21) Numéro de dépôt: 03799622.0
(22) Date de dépôt: 18.12.2003
(51) Int. Cl.: G03F 7/095, G03F 7/00, B81B 1/00

(54) **MICROSTRUCTURE COMPORTANT UNE COUCHE D'ADHERENCE ET PROCEDE DE FABRICATION D'UNE TELLE MICROSTRUCTURE**
EINE HAFTSCHICHT UMFASSENDE MIKROSTRUKTUR UND VERFAHREN ZUR HERSTELLUNG EINER SOLCHEN MIKROSTRUKTUR
MICROSTRUCTURE COMPRISING AN ADHESIVE COATING AND METHOD FOR MAKING SAME

(30) Priorité: 20.12.2002 FR 0216272
(43) Date de publication de la demande: 14.09.2005
(73) Titulaire: COMMISSARIAT A L'ENERGIE ATOMIQUE, 75752 Paris (FR)
(72) Inventeur: RABAROT, Marc, F-38120 Saint-Egreve (FR); BABLET, Jacqueline, F-38450 Le Gua (FR)
(74) Mandataire: Jouvray, Marie-Andrée
(86) Numéro de dépôt international: PCT/FR2003/003788
(87) Numéro de publication internationale: WO 2004/063817

(56) Documents cités:
- EP-A- 0 851 295
- WO-A-01/37050
- DE-A- 3 702 897
- US-A- 2 964 401
- "Photosensitive material for forming image, consists of a support provided with a photosensitive layer and hardenable layer which is surface treated by corona and flow discharge" DERWENT, 31 mai 1994 (1994-05-31), XP002258655
- "Removal of image by resist film lead frame - by laminating new pressure-sensitive adhesive or adhesive sheet, which is curable, on image using resist film, hardening adhesive layer and releasing laye with resist" DERWENT, 26 mai 2000 (2000-05-26), XP002258656
- PATENT ABSTRACTS OF JAPAN vol. 0124, no. 07 (E-675), 27 octobre 1988 (1988-10-27) & JP 63 146599 A (KYORITSU KAGAKU SANGYO KK; others: 02), 18 juin 1988 (1988-06-18)

## Description

### Domaine technique de l'invention

L'invention concerne une microstructure comportant une couche d'adhérence entre un substrat et une couche photostructurable, la couche d'adhérence étant photosensible et disposée sur au moins une face du substrat.

L'invention concerne également un procédé de fabrication d'une telle microstructure.

### État de la technique

Les microstructures comportant des couches épaisses sont généralement utilisées soit directement, par exemple comme composants en micromécanique, soit indirectement comme structures positives sacrificielles pour la fabrication de micro-moules métalliques. Il est connu de réaliser de telles microstructures à partir d'au moins une couche photosensible en résine négative de type époxy telle que celle commercialisée par Micro-Chemical Corporation sous la référence SU-8. Ce type de couche photosensible peut être mis en oeuvre par un procédé de fabrication connu sous le nom de LIGA-UV et dérivant du procédé LIGA (« Lithographie Galvaniserung Abformung »).

Le procédé LIGA-UV consiste à déposer sur un substrat une couche de résine photosensible. La couche de résine photosensible est séchée, puis irradiée par rayonnement ultraviolet (UV) à travers un masque. Elle subit, ensuite, un recuit et elle est développée, c'est-à-dire que, pour une résine négative, les portions de résine non polymérisées par irradiation UV et recuit sont éliminées par des moyens physiques ou chimiques. Ceci permet de réaliser des microstructures de facteur de forme élevé. Par facteur de forme, on entend un rapport critique de la hauteur sur la largeur d'un motif, un motif correspondant à l'espace libéré par une portion de résine non polymérisée, dans le cas de l'utilisation d'une résine photosensible négative.

A titre d'exemple, le document EP-A1-0851295 décrit un procédé de fabrication de microstructures par conformation multicouche d'une résine négative photosensible de type époxy. Les microstructures sont réalisées en créant sur une plaquette-support un revêtement sacrificiel métallique et en structurant au moins deux couches de résine photosensible négative. Les couches structurées sont ensuite détachées de la plaquette-support en effectuant une attaque alcaline de la couche sacrificielle.

La forte épaisseur des couches en résine photosensible ainsi que la géométrie du masque, les dimensions de la microstructure obtenue et la nature du substrat sont des paramètres pouvant induire de fortes contraintes dans le substrat. Les contraintes peuvent être à l'origine d'une diminution de l'adhérence entre la couche photosensible et le substrat et ceci peut entraîner un décollement de motif, soit directement à l'issue de l'étape de développement, soit dans la suite du cycle de fabrication.

Pour éviter de tels décollements, certains ont tenté de modifier les paramètres du procédé, notamment en abaissant la température de recuit et / ou la dose d'irradiation. Ceci n'est pas satisfaisant car ces modifications peuvent augmenter la durée du procédé et ne permettent pas de diminuer les contraintes liées à la géométrie du masque ou à la nature du substrat.

Une autre technique consiste à utiliser une couche intermédiaire d'adhérence entre la couche photosensible et le substrat. Ainsi le document WO-A1-0137050 décrit une couche d'adhérence constituée par un polymère de la famille des polyimides ou d'un mélange de polyimides. Cependant, ce polymère n'est pas satisfaisant car il a une température de polymérisation élevée, généralement comprise entre 250°C et 400°C. Ceci peut être limitant dans la mise en oeuvre du procédé de fabrication des microstructures, notamment avec des substrats en matière plastique.

### Objet de l'invention

L'invention a pour but une microstructure remédiant à ces inconvénients.

Selon l'invention, ce but est atteint par le fait que la couche d'adhérence est constituée par une résine négative comportant au moins un polymère de la famille des élastomères et au moins un composant photo-amorçeur, en solution dans un solvant aromatique.

Selon un développement de l'invention, le polymère est un polyisoprène cyclique en solution dans du xylène.

Selon un mode de réalisation préférentiel, la couche d'adhérence a une épaisseur comprise entre 200nm et 10µm.

Selon une autre caractéristique de l'invention, la couche photostructurable est constituée par au moins une résine négative de type époxy.

L'invention a également pour but un procédé de fabrication d'une telle microstructure.

Selon l'invention, le procédé de fabrication comporte l'étalement et le séchage d'une couche d'adhérence constituée par une résine négative comportant au moins un polymère de la famille des élastomères et au moins un composant photo-amorçeur, en solution dans un solvant aromatique, avant le dépôt d'au moins une couche photostructurable en résine.

Selon un développement de l'invention, la couche d'adhérence est insolée à travers un masque et développée, avant le dépôt de la couche photostructurable.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
Les figures 1 à 5 et 6 à 9 représentent respectivement différentes étapes d'un premier et d'un second modes de réalisation d'une microstructure selon l'invention.
Les figures 10 et 11 représentent une variante de réalisation du second mode de réalisation d'une microstructure selon l'invention.
Les figures 12 à 13 et 14 à 17 représentent respectivement différentes étapes d'un troisième et d'un quatrième modes de réalisation d'une microstructure selon l'invention.

### Description de modes particuliers de réalisation.

Une microstructure, de préférence destinée à être utilisée comme composant en micromécanique ou comme structure positive sacrificielle pour la fabrication de micro-moules métalliques, est réalisée à partir d'au moins une couche photostructurable et un substrat par un procédé de type LIGA-UV. Par couche photostructurable, on entend une couche sensible au rayonnement ultraviolet et destinée à être structurée pour former des motifs. La couche photostructurable est, de préférence, constituée par au moins une résine négative de type époxy, et plus particulièrement par la résine SU-8 commercialisée par la société Micro-Chemical Corporation. Elle a, de préférence, une épaisseur comprise entre 50µm et 200µm.

Une couche d'adhérence destinée à améliorer l'adhérence entre le substrat et la couche photostructurable est disposée sur au moins une face du substrat et elle a, de préférence, une épaisseur comprise entre 200nm et 10µm. La couche d'adhérence est photosensible, c'est-à-dire sensible au rayonnement ultraviolet et elle est constituée par une résine négative comportant au moins un polymère de la famille des élastomères et au moins un composant photo-amorçeur, en solution dans un solvant aromatique. Le polymère est, de préférence, un polyisoprène cyclique en solution dans du xylène, et par exemple choisi parmi la gamme des résines photosensibles commercialisées sous le nom de SC Resist par la société Olin Micorelectronic Materials.

La résine de la couche d'adhérence présente l'avantage d'avoir une température de polymérisation inférieure à 135°C et elle peut absorber les contraintes qui s'établissent entre le substrat et la couche photostructurable. De plus, sa faible épaisseur notamment par rapport à l'épaisseur de la couche photostructurable en résine époxy, permet de supprimer l'influence de la géométrie de la microstructure et la nature du substrat.

La résine appartenant à la famille des élastomères, elle peut créer des liaisons organo-chimiques entre les résines époxy et la plupart des matériaux constituant le substrat. Ainsi, le substrat peut être constitué par un matériau choisi parmi le silicium, le verre et les matières plastiques, notamment le polycarbonate, le polyméthyle méthacrylate (PMMA) ou le cyclo oléfine copolymère (COC), selon les applications visées. Le substrat peut également être recouvert par une sous-couche conductrice disposée entre le substrat et la couche d'adhérence. La couche conductrice est, de préférence, métallique et notamment en or, en nickel ou en alliage fer-nickel, de cuivre, de titane, de chrome ou d'aluminium. La couche d'adhérence permet également une bonne adhérence entre la résine de type époxy et une sous-couche conductrice.

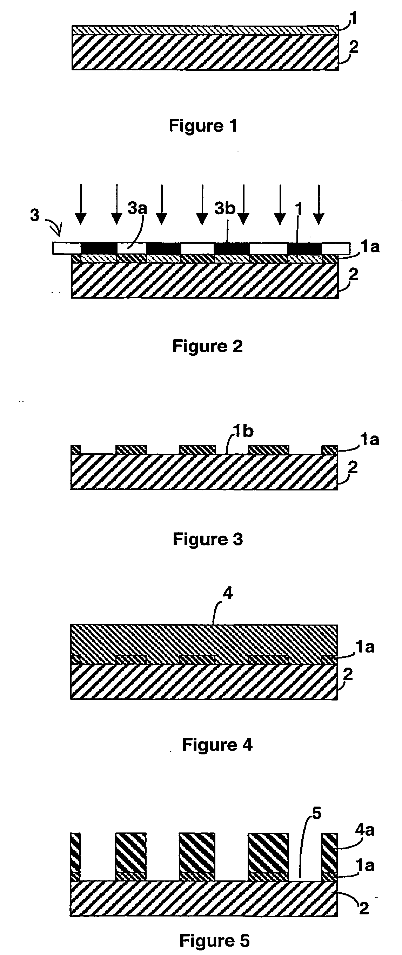

Selon un premier mode de réalisation représenté sur les figures 1 à 5, une microstructure est réalisée en étalant une couche d'adhérence 1 sur un substrat 2 (figure 1). La couche d'adhérence 1 a, de préférence, une épaisseur de 2,5µm et elle est constituée par une résine négative comportant au moins un polymère de la famille des élastomères et au moins un composant photo-amorçeur, en solution dans un solvant aromatique. La couche d'adhérence 1 est, de préférence, une résine de type SC Resist.

La couche d'adhérence 1 est séchée pendant 10 minutes, à une température comprise entre 75°C et 95°C et, de préférence, à 85°C. Puis, elle est soumise à une insolation par rayonnement ultraviolet (représenté par des flèches sur la figure 2), à travers un masque 3. L'insolation par rayonnement ultraviolet est, de préférence, de 200 à 1000 mJ.cm⁻² à une longueur d'onde de 365nm. Le masque 3 comporte une pluralité de premières et secondes zones 3a et 3b respectivement transparentes et opaques au rayonnement ultraviolet. Ainsi, il permet d'insoler localement des zones 1 a de la couche d'adhérence 1 en résine négative, lesdites zones 1a étant disposées en regard des premières zones 3a du masque 3.

La couche d'adhérence 1 subit alors un recuit destiné à provoquer la polymérisation des zones 1 a insolées de la couche d'adhérence 1. A titre d'exemple, le recuit est réalisé à une température comprise entre 90 et 95°C pendant 15 à 30 minutes La couche d'adhérence 1 est ensuite développée par tout type de moyens connus, de manière à éliminer les zones non insolées et non polymérisées de la couche d'adhérence 1 et à révéler des motifs 1 b (figure 3). Ainsi, la couche d'adhérence 1 peut être développée dans un bain de solvant tel que du propylène glycol méthyléther acétate, plus connu sous le nom de PGMEA, de sorte que les zones non insolées de la couche d'adhérence se dissolvent dans le solvant.

Une couche photostructurable 4, en résine négative de type époxy et, de préférence en résine SU-8, est étalée sur la couche d'adhérence révélée et sur le substrat 2. Elle a, de préférence, une épaisseur de 150µm et elle subit un traitement de type LIGA-UV similaire à celui subit par la couche d'adhérence 1. Ainsi, elle est séchée et insolée par rayonnement ultraviolet à travers un masque (non représenté sur les figures 4 et 5). Le masque peut être identique ou légèrement différent du masque 3 ayant servi à révéler la couche d'adhérence 1. Sur la figure 5, le masque utilisé est identique au masque 3 utilisé pour la couche d'adhérence 1, de sorte que des zones insolées 4a de la couche photostructurable 4 coïncident, en largeur, avec les zones insolées 1a de la couche d'adhérence 1 (figure 5). Ainsi, une fois la couche photostructurable 4 développée, les motifs révélés par l'insolation de la couche photostructurale 4 se superposent aux motifs 1 a révélés par l'insolation de la couche d'adhérence 1 pour former des motifs 5 exposant le substrat 2.

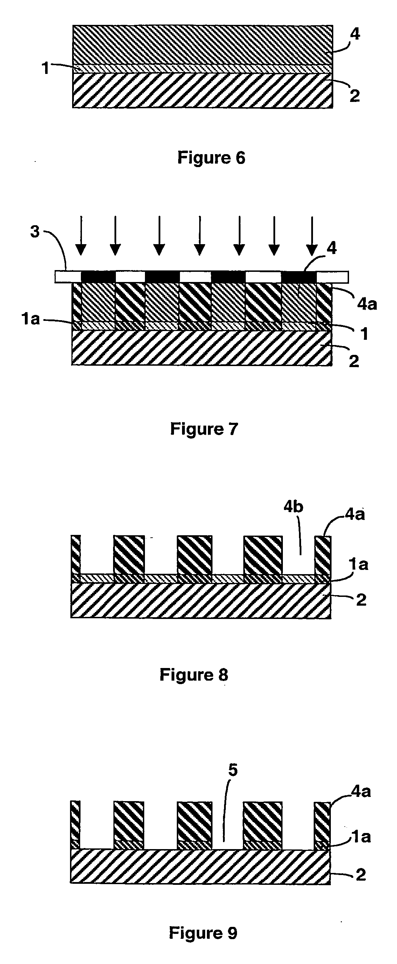

Selon un second mode de réalisation représenté sur les figures 6 à 9, la couche d'adhérence 1 et la couche photostructurable 4 sont successivement étalées sur le substrat 1 et séchées (figure 6). La couche photostructurable 4 est alors insolée localement par rayonnement ultraviolet (représenté par des flèches sur la figure 7) à travers le masque 3. La couche photostructurable 4 subit alors un recuit destiné à polymériser les zones insolées 4a. Elle est alors développée spécifiquement de manière à révéler des motifs 4b issus de l'élimination des zones non insolées de la couche photostructurable 4 (figure 8).

La couche d'adhérence étant en résine photosensible négative, l'insolation par rayonnement ultraviolet provoque non seulement la réticulation localisée de la couche photostructurable 4 mais aussi celle de la couche d'adhérence 1. La couche d'adhérence 1 peut alors être développée spécifiquement pour révéler des motifs coïncidant, en largeur, avec les motifs 4b, de manière à former des motifs 5 exposant le substrat 2 (figure 9). Ce mode de réalisation est particulièrement intéressant, notamment dans le cas où la structure du substrat (ou de la sous-couche intermédiaire) n'est pas compatible avec un autre procédé de structuration.

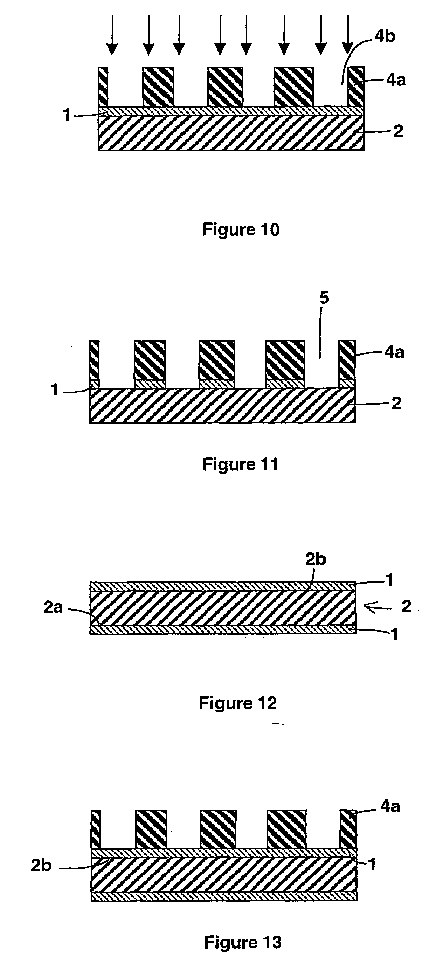

Selon une variante de réalisation représentée sur les figures 10 et 11, la couche d'adhérence 1 et la couche photostructurable 4 sont mises en oeuvre selon le mode de réalisation représenté sur les figures 6 à 8, de manière à révéler les motifs 4b issus du développement de la couche photostructurable 4 (figure 10). La couche d'adhérence 1 est alors gravée localement par plasma réactif (figure 10), de manière à révéler des motifs se superposant aux motifs 4b pour former des motifs 5 (figure 11). Les zones insolées 4a de la couche photostructurable 4 et les motifs 4b font alors office de masque pendant la gravure de la couche d'adhérence 1.

La couche d'adhérence 1 entre le substrat et la couche photostructurable permet plus particulièrement d'utiliser un substrat 2 en matière plastique, par exemple en polycarbonate ou en polyméthyle méthacrylate (PMMA), avec une couche photostructurable 4 en résine de type époxy. En effet, il n'est pas toujours possible d'étaler directement une couche en résine de type époxy telle que la résine SU-8 sur un substrat en matière plastique. Les solvants utilisés, notamment dans la résine SU-8, peuvent être les mêmes que ceux des polymères utilisés pour le substrat en matière plastique. Dans ce cas, lors de l'étalement et du développement de la résine SU-8, le substrat peut subir une attaque chimique des solvants contenus dans la résine SU-8 ou dans le bain de développement. La couche d'adhérence 1 permet alors de protéger le substrat en matière plastique.

Ainsi, sur les figures 12 et 13, la couche d'adhérence 1 est disposée sur les faces inférieure 2a et supérieure 2b du substrat 2, de manière à le préserver des attaques de solvants contenus dans la couche photostructurable 4 structurée selon un procédé de type LIGA-UV, et de ceux contenus dans le bain de développement. Selon l'application visée, la totalité de la couche d'adhérence 1 peut être, préalablement, insolée par rayonnement ultraviolet,. Ceci permet plus particulièrement de réaliser des microcomposants en utilisant un substrat en matière plastique.

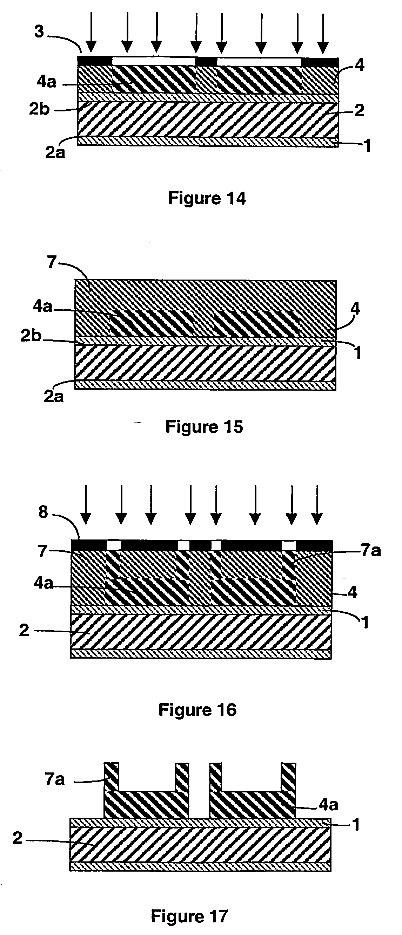

Selon un autre mode de réalisation représenté sur les figures 14 à 17, la couche d'adhérence 1 est disposée et séchée sur les faces supérieure 2b et inférieure 2a du substrat 2. Une première couche photostructurable 4 en résine SU-8 est étalée sur la couche d'adhérence 1 disposée sur la face supérieure 2b du substrat 2. Elle est séchée, insolée par rayonnement ultraviolet à travers un premier masque 3 (figure 14) puis recuite, de manière à délimiter deux zones polymérisées 4a. Une seconde couche photostructurable 7 en résine SU-8 est étalée sur la première couche photostructurable 4 (figure 15). La seconde couche photostructurable 7 est également séchée, insolée à travers un second masque 8 et recuite, de manière à délimiter quatre zones insolées et polymérisées 7a.

Dans le mode de réalisation représenté sur la figure 16, le second masque 8 est différent du premier masque 3, de manière à délimiter dans la seconde couche photostructurable 7 quatre zones insolées 7a ayant une section moins large que les deux zones 4a. Sur la figure 16, les quatre zones 7a sont donc disposées, deux à deux, sur une même zone 4a, de manière à prolonger les zones 4a vers le haut sur la figure 16 et à former une structure empilée en forme de gouttière. Les première et seconde couches photostructurables 4 et 7 sont ensuite développées simultanément, de manière à éliminer les parties non insolées des première et seconde couches photostructurables 4 et 7 et à libérer la structure empilée (figure 17). Ceci permet de réaliser des composants ou des micro-moules de géométrie complexe et, par exemple, des micro-cellules par prototypage rapide sur un substrat en matière plastique ou en verre.

La microstructure et le procédé de fabrication d'une telle microstructure selon l'invention présentent l'avantage d'éviter le décollement des motifs créés par le procédé LIGA-UV. Ils permettent également d'utiliser différentes natures de substrat et notamment des substrats en matière plastique.

Le procédé de fabrication et la microstructure selon l'invention sont particulièrement adaptés à la fabrication rapide de composants ou de systèmes microfluidiques, biotechnologiques ou microoptiques et de micropiles à combustible. Il est également possible de découper le substrat en puces, notamment lorsque le substrat est en silicium, sans provoquer le décollement des motifs créés.

## Revendications

1. Microstructure comportant une couche d'adhérence (1) entre un substrat (2) et une couche photostructurable (4), la couche d'adhérence (1) étant photosensible et disposée sur au moins une face du substrat (2), microstructure **caractérisée en ce que** la couche d'adhérence (1) est constituée par une résine négative comportant au moins un polymère de la famille des élastomères et au moins un composant photo-amorçeur, en solution dans un solvant aromatique.

2. Microstructure selon la revendication 1, **caractérisée en ce que** le polymère est un polyisoprène cyclique en solution dans du xylène.

3. Microstructure selon l'une des revendications 1 et 2, **caractérisée en ce que** la couche d'adhérence (1) a une épaisseur comprise entre 200nm et 10µm.

4. Microstructure selon l'une quelconque des revendications 1 à 3, **caractérisée en ce que** la couche photostructurable (4) est constituée par au moins une résine négative de type époxy.

5. Microstructure selon l'une quelconque des revendications 1 à 4, **caractérisée en ce que** la couche photostructurable (4) a une épaisseur comprise entre 50µm et 200µm.

6. Microstructure selon l'une quelconque des revendications 1 à 5, **caractérisée en ce que** le substrat (2) est constitué par un matériau choisi parmi le silicium, le verre et les matières plastiques.

7. Procédé de fabrication d'une microstructure selon l'une quelconque des revendications 1 à 6, **caractérisée en ce que** le procédé comporte l'étalement et le séchage d'une couche d'adhérence (1) constituée par une résine négative comportant au moins un polymère de la famille des élastomères et au moins un composant photo-amorçeur, en solution dans un solvant aromatique, avant le dépôt d'au moins une couche photostructurable (4) en résine.

8. Procédé de fabrication selon la revendication 7, **caractérisé en ce que** la couche d'adhérence (1) est insolée à travers un masque (3) et développée, avant le dépôt de la couche photostructurable (4).

9. Procédé de fabrication selon la revendication 7, **caractérisé en ce que** la couche d'adhérence (1) et la couche photostructurable (4) sont insolées simultanément à travers un masque (3).

10. Procédé de fabrication selon la revendication 9, **caractérisé en ce que** la couche photostructurable (4) et la couche d'adhérence (1) sont développées successivement.

11. Procédé de fabrication selon la revendication 7, **caractérisé en ce qu'**au moins deux couches photostructurables (4, 7) sont développées simultanément, après avoir été successivement déposées et insolées à travers deux masques (3, 8) différents.

## Claims

1. Microstructure comprising an adhesive layer (1) between a substrate (2) and a photo-patternable layer (4), the adhesive layer (1) being photosensitive and arranged on at least one face of the substrate (2), microstructure **characterized in that** the adhesive layer (1) is formed by a negative resin comprising at least one polymer of the elastomer family and at least one photo-initiating component, in solution in an aromatic solvent.

2. Microstructure according to claim 1, **characterized in that** the polymer is a cyclic polyisoprene in solution in xylene.

3. Microstructure according to one of the claims 1 and 2, **characterized in that** the adhesive layer (1) has a thickness comprised between 200nm and 10µm.

4. Microstructure according to any one of the claims 1 to 3, **characterized in that** the photo-patternable layer (4) is formed by at least one negative resin of epoxy type.

5. Microstructure according to any one of the claims 1 to 4, **characterized in that** the photo-patternable layer (4) has a thickness comprised between 50µm and 200µm.

6. Microstructure according to any one of the claims 1 to 5, **characterized in that** the substrate (2) is formed by a material chosen from silicon, glass and plastics.

7. Method of fabrication of a microstructure according to any one of the claims 1 to 6, **characterized in that** the method comprises spreading and drying of an adhesive layer (1) formed by a negative resin comprising at least one polymer of the elastomer family and at least one photo-initiating component, in solution in an aromatic solvent, before deposition of at least one photo-patternable layer (4) of resin.

8. Fabrication method according to claim 7, **characterized in that** the adhesive layer (1) is exposed through a mask (3) and developed, before deposition of the photo-patternable layer (4).

9. Fabrication method according to claim 7, **characterized in that** the adhesive layer (1) and the photo-patternable layer (4) are exposed simultaneously through a mask (3).

10. Fabrication method according to claim 9, **characterized in that** the photo-patternable layer (4) and the adhesive layer (1) are developed successively.

11. Fabrication method according to claim 7, **characterized in that** at least two photo-patternable layers (4, 7) are developed simultaneously, after having been successively deposited and exposed through two different masks (3, 8).

## Patentansprüche

1. Mikrostruktur, die eine Haftschicht (1) zwischen einem Substrat (2) und einer fotostrukturierbaren Schicht (4) umfasst, wobei die Haftschicht (1) lichtempfindlich und auf mindestens einer Seite des Substrats (2) angeordnet ist, eine Mikrostruktur, die **dadurch gekennzeichnet ist, dass** die Haftschicht (1) von einem negativen Fotoresist gebildet wird, das mindestens ein Polymer aus der Gruppe der Elastomere und mindestens einen fotoinitiierenden Bestandteil aufweist, der in einem aromatischen Lösungsmittel gelöst ist.

2. Mikrostruktur nach Anspruch 1, **dadurch gekennzeichnet, dass** das Polymer ein zyklisches Polyisopren ist, das in Xylen gelöst ist.

3. Mikrostruktur nach einem der Ansprüche 1 und 2, **dadurch gekennzeichnet, dass** die Haftschicht eine Dicke von 200 nm bis 10 µm hat.

4. Mikrostruktur nach einem der Ansprüche 1 bis 3, **dadurch gekennzeichnet, dass** die fotostrukturierbare Schicht (4) von mindestens einem negativen Resist auf Basis von Epoxidharzen gebildet wird.

5. Mikrostruktur nach einem der Ansprüche 1 bis 4, **dadurch gekennzeichnet, dass** die fotostrukturierbare Schicht (4) eine Dicke von 50 bis 200 µm hat.

6. Mikrostruktur nach einem der Ansprüche 1 bis 5, **dadurch gekennzeichnet, dass** das Substrat (2) aus einem Material besteht, das aus der aus Silizium, Glas und Kunststoffen gebildeten Gruppe ausgewählt ist.

7. Herstellungsverfahren für eine Mikrostruktur nach einem der Ansprüche 1 bis 6, **dadurch gekennzeichnet, dass** das Herstellungsverfahren das Aufbringen und Trocknen einer Haftschicht (1) umfasst, die aus einem negativen Fotoresist besteht, das mindestens ein Polymer aus der Gruppe der Elastomere und mindestens einen fotoinitiierenden Bestandteil umfasst, der vor dem Aufbringen mindestens einer fotostrukturierbaren Resistschicht (4) in einem aromatischen Lösungsmittel gelöst ist.

8. Herstellungsverfahren nach Anspruch 7, **dadurch gekennzeichnet, dass** die Haftschicht (1) vor dem Aufbringen der fotostrukturierbaren Schicht (4) durch eine Maske (3) hindurch belichtet und entwickelt wird.

9. Herstellungsverfahren nach Anspruch 7, **dadurch gekennzeichnet, dass** die Haftschicht (1) und die fotostrukturierbare Schicht (4) gleichzeitig durch eine Maske (3) hindurch belichtet werden.

10. Herstellungsverfahren nach Anspruch 9, **dadurch gekennzeichnet, dass** die fotostrukturierbare Schicht (4) und die Haftschicht (1) nacheinander entwickelt werden.

11. Herstellungsverfahren nach Anspruch 7, **dadurch gekennzeichnet, dass** mindestens zwei fotostrukturierbare Schichten (4, 7) gleichzeitig entwickelt werden, nachden sie nacheinander aufgebracht und durch zwei unterschiedliche Masken (3, 8) hindurch belichtet wurden.
